# EUROPEAN PATENT APPLICATION

(11) **EP 2 985 794 A1**
(43) Date of publication of application: **17.02.2016**
(21) Application number: 14782793.5
(22) Date of filing: 03.02.2014
(51) Int. Cl.: H01L 33/62, H01L 33/48

(54) **SUBSTRATE FOR MOUNTING LED**

(30) Priority: 08.04.2013 JP 2013080476
(71) Applicant: Tateyama Kagaku Industry Co., Ltd., Toyama-shi, Toyama 939-8051 (JP)
(72) Inventor: HONDA Kenichi, Toyama-shi Toyama 930-1305 (JP); INODA Akihiro, Toyama-shi Toyama 930-1305 (JP); HIROSE Keiichi, Toyama-shi Toyama 930-1305 (JP)
(74) Representative: Zimmermann & Partner Patentanwälte mbB
(86) International application number: PCT/JP2014/052405
(87) International publication number: WO 2014/167886

(57) **Abstract**

Provided is a low-cost LED mounting substrate capable of allowing an emission color of an LED to be clearly output, without being additionally subjected to coating. The LED mounting substrate comprises a flexible insulating substrate (1) made of a paper material, and a circuit pattern (2) composed mainly of solder and coveringly attached onto the insulating substrate (1) in such a manner as to include an LED mounting land.

## Description

### TECHNICAL FIELD

The present invention relates to circuit substrate, and particularly to a flexible circuit substrate for mounting a light emitting diode (LED).

### BACKGROUND ART

Heretofore, LEDs have been used in various fields. Nowadays, they are also used as an illumination function, and an application range thereof is deemed to be more expanded, partly in conjunction with flexibilization of a circuit substrate.

As a circuit substrate having flexibility, a polyimide substrate and a PET substrate have heretofore been widely known. Further, when an LED is mounted thereon, a soldering material, a conductive resin adhesive or the like is used.

Comparing the soldering material with the conductive resin adhesive, the soldering material is more desirable in terms of reliability and heat-dissipatability. However, for soldering, it is necessary to select a copper pattern as a circuit pattern, and select a polyimide substrate having heat resistance.

### CITATION LIST

### [Patent Document]

Patent Document 1: JP 2006-324608A
Patent Document 2: JP 2010-205954A

### SUMMARY OF INVENTION

### [Technical Problem]

However, each of the copper pattern and the polyimide substrate has a brownish-red color and exhibits poor reflection efficiency (see the Patent Document 2). Thus, in order to allow an emission color of an LED to be clearly output, each of them needs to be additionally formed with a white color coating layer or a metal layer having high reflection efficiency (see the Patent Document 1 or the Patent Document 2).

Moreover, the polyimide substrate is relatively expensive, i.e., involves a cost problem.

The present invention has been made in view of the above circumstance, and an object thereof is to provide a low-cost LED mounting substrate capable of allowing an emission color of an LED to be clearly output, without additional coating.

### [Solution to Technical Problem]

In order to solve the above problems, the present invention provides an LED mounting substrate which comprises: a flexible insulating substrate made of a paper material; and a solder foil pattern coveringly attached onto the insulating substrate in such a manner as to include an LED mounting land.

The LED mounting substrate may employ a structure in which the insulating substrate has a first surface on which the solder foil pattern is formed, and a second surface which is located on a side opposite to the first surface and on which a heat radiation pattern made of a flexible metal material such as aluminum foil is formed.

Examples of an illumination device using the LED mounting substrate include an illumination device in which the circuit pattern is formed into a lattice or mesh pattern, and the insulating substrate is bent and formed to allow the circuit pattern to be located within the interior of the bent insulating substrate.

In order to enhance heat-dissipation efficiency, a fiber density of a paper material constituting the insulating substrate may be increased, or the heat radiation pattern may be coveringly attached, in the form of a lattice or mesh pattern, onto the second surface of the insulating substrate on the side opposite to the first surface thereof on which the circuit pattern is formed.

### [Effect of Invention]

According to the present invention, a soldering material advantageous in terms of reliability and heat-dissipatability can be employed rather than using any conductive resin adhesive. Also, based on a structure using an insulating substrate which is made of a paper material and onto which a solder foil pattern serving as a circuit pattern and having high light reflection efficiency is coveringly attached, it becomes possible to provide, at low cost, a LED mounting substrate having flexibility and capable of allowing an emission color of an LED mounted thereon to be clearly output, without additionally providing a white color coating layer, a metal layer having high reflection efficiency or the like.

Meanwhile, with a view to reducing thermal damage to an LED, in some cases the LED is mounted using a low-melting-point solder composed mainly of a bismuth component. However, such a low-melting-point solder is generally considered to be more likely to cause mounting defects due to poor solder wettability with respect to a land pattern made of copper foil.

On the other hand, the LED mounting substrate of the present invention is substantially configured such that a certain region surrounding an LED-mounting area is coated with an auxiliary solder for providing good solder wettability. This provides an advantage of being able to suppress the occurrence of mounting defects even using a low-melting-point solder, while obtaining high electric conductivity and heat-releasability.

### BRIEF DESCRIPTION OF DRAWINGS

FIG. 1 is a top plan view illustrating an LED mounting substrate according to one embodiment of the present invention.
FIG. 2 is a vertical sectional view illustrating the LED mounting substrate according to this embodiment.

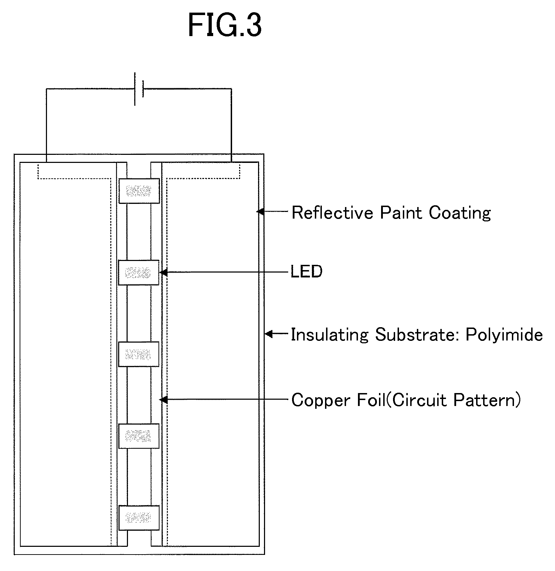

FIG. 3 is a top plan view illustrating one example of a conventional LED mounting substrate.

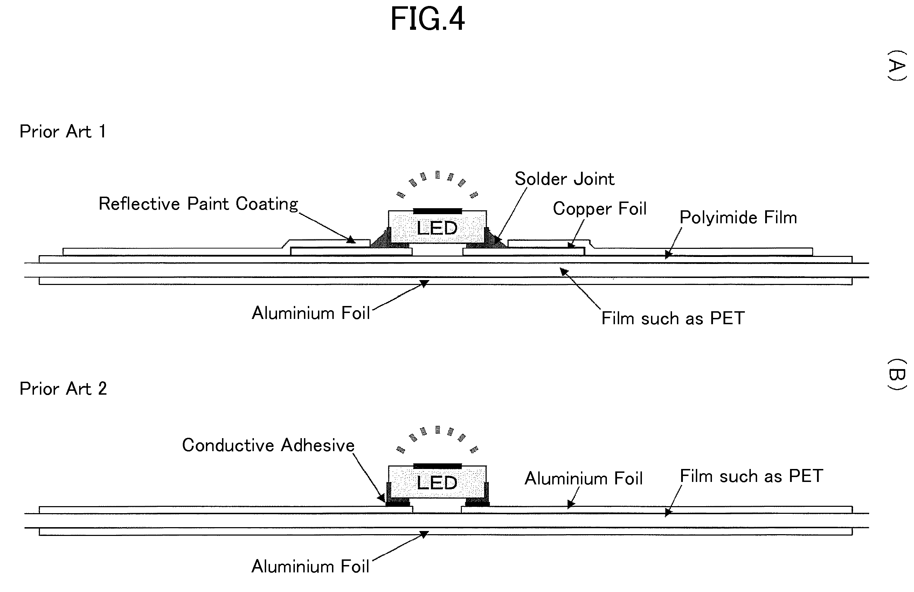

FIGS. 4(A) and 4(B) are, respectively, vertical sectional views illustrating two examples of the conventional LED mounting substrate.
FIG. 5 is a table presenting a light reflectance property in a visible light region, in an example of an LED mounting substrate of the present invention.

### DESCRIPTION OF EMBODIMENTS

With reference to the drawings, an LED mounting substrate according to one embodiment of the present invention will now be described.

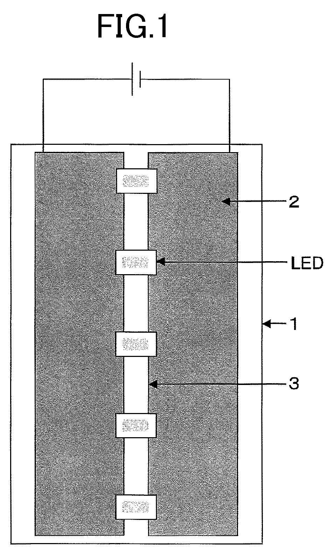

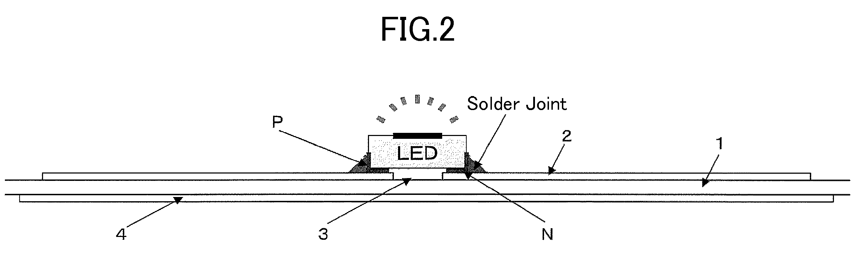

An LED mounting substrate illustrated in FIGS. 1 and 2 is configured such that a pair of rectangular-shaped solid patterns (circuit patterns 2) each having approximately the same size are coveringly attached onto or formed on a surface of a flexible insulating substrate 1 made of a paper material, while interposing therebetween a gap 3 having an uniform width equivalent to an interval between an anode terminal P and a cathode terminal N of a target LED to be mounted. A power supply circuit is connected to the paired circuit patterns 2 so as to drive the LED and control an operation of the LED.

### < Insulating Substrate >

The insulating substrate 1 may be any sheet-shaped insulating substrate prepared by a technique of subjecting insulating fibers among plant fibers and non-plant fibers (synthetic resin fibers, glass fibers, etc.) to papermaking and/or pressurization, and consolidating the resulting insulating fibers using an insulating adhesive. Further, practical utility thereof in harsh environments can be enhanced, for example, by using a functional paper having excellent burning resistance and heat resistance, such as glass fibers or aramid fibers.

In the case where it is intended to avoid impairing a color tone of emitted light of an LED, as a color tone to be selected, a while color tone is desirable.

On the other hand, in the case where it is necessary to enhance moisture resistance, a moisture-resistant coating material may be applied or coated as an upper layer of the insulating substrate 1 or the circuit pattern 2. Further, in the case where it is necessary to change (adjust) color tone (color, brightness, etc.) of light as the entire insulating substrate 1, a moisture-resistant coating material capable of projecting a color tone fitting the intended purpose may be selected.

In the case where it is necessary to allow the insulating substrate 1 itself to have a heat-radiation effect, fibers as a raw material for the insulating substrate 1 may be subjected to calendaring processing to press the fibers under a high pressure to thereby increase a fiber density of the insulating substrate. This makes it possible to provide enhanced heat conductivity and enhanced insulation property.

In the case where it is necessary to enhance heat-releasability, in the insulating substrate 1 having a first surface on which the circuit pattern is formed, a heat-releasing pattern may be formed on a second surface of the insulating substrate 1 on a side opposite to the first surface, by using a foil made of a flexible metal material such as aluminum.

### < Circuit Pattern >

The circuit pattern 2 is formed by: adding a slight amount of nickel component to a tin-copper alloy to prepare a tin-copper-nickel based alloy, called "solder"; and coveringly attaching the solder onto the insulating substrate 1 in the form of a foil (thin film).

The use of the solder makes it possible to enhance specular reflection efficiency of light. It is also possible to enhance diffuse reflection efficiency by adding silver as a raw material, or by providing irregularities in a surface of the insulating substrate and then coveringly attaching a solder foil onto the resulting surface. In the case of adding silver, an amount of the additional component such as nickel is appropriately adjusted.

In the illustrated embodiment, a part of lateral edges of the pair of solid patterns (circuit patterns 2) along the gap 3 is used as an LED mounting land.

Examples of a technique of forming a circuit pattern 2 made of the solder, on the insulating substrate 1 include: a technique of bonding a solder foil cut into a shape of a desired circuit pattern 2, onto a paper material by using an adhesive; a technique of applying solder to a surface of the insulating substrate 1 to form a circuit pattern 2 by means of vapor-deposition or plating; a technique of coating a surface of the insulating substrate 1 with a component for facilitating adhesion of molten solder (e.g., a phenolic resin containing silver-coated copper or nickel particles, or particles of an alloy thereof), in a shape conforming to a desired circuit pattern, and then adhering molten solder onto the coating; and a technique of: after applying a paint containing solder particles, to the insulating substrate 1, melting the solder particles by heating; and causing the molten solder particles to be re-solidified and thereby coveringly attached onto the insulating substrate 1.

### < Mode of Circuit Pattern >

The circuit pattern is not limited to a solid pattern, but may be any other suitable pattern, such as a lattice or grid pattern, a spiral pattern, a meandering or zigzag pattern, or a small mesh pattern. In any case, good effects can be obtained. The circuit pattern 2 is required to ensure a minimal reflective area and configuration necessary for allowing an emission color of an LED mounted thereto to be clearly output, around the mounting area.

As a technique for forming the circuit pattern, it is possible to appropriately select one of a plurality of techniques comprising: discharging or printing of a circuit pattern-forming conductive paste; and foil stamping or transfer printing using a circuit pattern-forming metal.

As above, the present invention can provide a multifunctional LED mounting substrate having flexibility originated from paper properties and capable of allowing light from an LED to be emitted with a desired color tone, without involving a cumbersome process and an increase in cost.

In the case where the insulating substrate is made of a paper material having optical transparency, the insulating substrate may be formed into a tubular shape or a folding screen-like shape having a mounting surface oriented inwardly. In this case, light from an LED is transmitted through a region of the paper insulating substrate other than an area to which a component having poor optical transparency, such as an electrode, a circuit pattern or a heat-dissipation pattern, is attached, thereby being able to obtain a light scattering effect. Thus, it is also possible to provide an illumination device capable of emitting transmitted light with a desired color tone.

### < Mounting >

In mounting using solder, examples of a technique for strengthening joining of an LED include: a technique of applying an adhesive between a land pattern and each of an anode terminal and a cathode terminal; and a technique of: preparing a mixture of solder formed into particles, a flux component and a thermosetting adhesive; and simultaneously melting and solidifying the solder particles and the thermosetting adhesive by one cycle of heating.

In the latter technique, with a view to reducing thermal damage to an LED, it is desirable to undergo a process of: in an atmospheric or nitrogen atmosphere, heating the mixture to a melting temperature of the solder particles; and, after completion of melting and integration, lowering a temperature of the atmosphere to solidify the thermosetting adhesive.

### EXAMPLES

An example of the LED mounting substrate of the present invention will be described below.

In this example, the insulating substrate 1 was prepared by: printing base paste (A-5000: Nippon Paint Anti-Corrosive Coatings Co., Ltd) on Nomex paper (Trademark: DuPont Teijin Advanced Papers, Ltd.) by means of screen printing; subjecting the printed paste to provisional drying on the condition that a solvent contained in the paste is vaporized in a tunnel drying furnace; and then subjecting the provisionally dried paste to final curing in a batch drying furnace at 160°C for 30 minute or more. As regards conditions for the curing, in the case of using a paper material which is likely to undergo a color change due to heating for a long period of time, the conditions are not limited to the above, but heating may be performed at a lower temperature for a longer period of time, e.g., at 130°C for 60 minute or more, to obtain an equivalent effect.

The aforementioned solder was melted and coated on the base paste to form the circuit pattern 2. As coating means, a dipping method using a molten solder bath or an application method using a soldering iron may be used. With a view to providing good wettability with the solder, a flux may be used, and, after using the flux, cleaning using a cleaning solvent may further be performed on a case-by-case basis.

The LED electrode, specifically, each of an anode terminal electrode and a cathode terminal electrode, was formed in a rectangular area of 20 x 75 mm in such a manner as to include an LED mounting land. The resulting coated solder had a thickness of about 10 µm, and a resistance value between diagonal edge positions of 10 mΩ or less.

An LED was mounted by: preparing a conductive joining material comprising a mixture of low-melting-point solder particles and a thermosetting adhesive (SAM10-401-27; produced by Tamura Corporation); heating the conductive joining material for 10 seconds, on a hot plate heated to 160°C as a temperature equal to or greater than a melting point of solder contained in the conductive joining material, to connect the LED and the circuit pattern together; and further heating the conductive joining material for 5 minutes, on the hot plate heated to 160°C, to perform final curing, thereby producing a desired substrate. In the case of using a paper material which is likely to undergo a color change due to heating for a long period of time, conditions for the final curing are not limited to the above, but heating may be performed at a temperature equal to or less than the melting point of the solder, for a longer period of time, e.g., at 130°C for 30 minute or more, to obtain an equivalent effect.

A given voltage was applied to the LED mounted to the circuit pattern 2 of the LED mounting substrate produced in the above manner to check an operation thereof. As a result, an emission of light could be obtained without any unevenness in brightness, and intended reflected light could be obtained from a surface of the circuit pattern 2 composed of the solder foil.

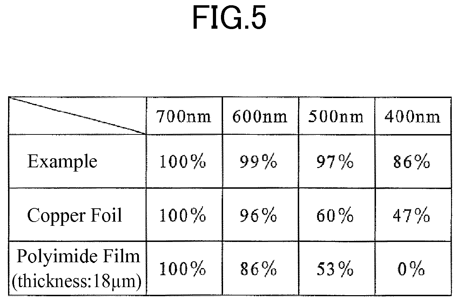

FIG. 5 is a table presenting a light reflectance property in a visible light region, in a prepared sample. A sample prepared in this example exhibited a flat reflectance property in a visible light region ranging from 700 nm (red) to 400 nm (purple), and it was ascertained that the circuit pattern can reflect light from the LED without impairing color of the light. Values in the table are calculated based on the assumption that a reflectance at a wavelength of 700 nm is 100%. As regards the polyimide film, a transmittance is used as a substitute.

### LIST OF REFERENCE SIGNS

P: anode terminal
N: cathode terminal
1: insulating substrate
2: circuit pattern
3: gap
4: heat-dissipation pattern

## Claims

1. An LED mounting substrate comprising: a flexible insulating substrate made of a paper material; and a circuit pattern composed mainly of solder and coveringly attached onto the insulating substrate in such a manner as to include an LED mounting land.

2. The LED mounting substrate as recited in claim 1, wherein the insulating substrate has a first surface on which the circuit pattern is formed, and a second surface which is located on a side opposite to the first surface and on which a heat-dissipation pattern made of a flexible metal material is formed.
